# EUROPEAN PATENT APPLICATION

(11) **EP 2 778 211 A1**
(43) Date of publication of application: **17.09.2014**
(21) Application number: 14157486.3
(22) Date of filing: 03.03.2014
(51) Int. Cl.: C09K 11/77, H01L 33/50

(54) **Phosphor and light-emitting device employing the same**

(30) Priority: 15.03.2013 JP 2013053697
(71) Applicant: Kabushiki Kaisha Toshiba, Tokyo 105-8001 (JP)
(72) Inventor: Albessard, Keiko, Minato-ku, Tokyo 105-8001 (JP); Fukuda, Yumi, Minato-ku, Tokyo 105-8001 (JP); Ishida, Kunio, Minato-ku, Tokyo 105-8001 (JP); Mitsuishi, Iwao, Minato-ku, Tokyo 105-8001 (JP); Matsuda, Naotoshi, Minato-ku, Tokyo 105-8001 (JP); Okada, Aoi, Minato-ku, Tokyo 105-8001 (JP); Hattori, Yasushi, Minato-ku, Tokyo 105-8001 (JP); Hiramatsu, Ryosuke, Minato-ku, Tokyo 105-8001 (JP); Kato, Masahiro, Minato-ku, Tokyo 105-8001 (JP)
(74) Representative: Granleese, Rhian Jane

(57) **Abstract**

The embodiment of the present disclosure provides a phosphor having such high luminous efficiency as to be capable of realizing a light-emitting device suffering less from color drift even when working with high power. This phosphor is a Ce-activated phosphor having a crystal structure of Sr₂Si₇Al₃ON₁₃, and emitting luminescence with a peak wavelength of 500 to 600 nm under excitation by light with a peak wavelength of 250 to 500 nm. The XRD profile of the phosphor measured with Cu-Kα line radiation according to Bragg-Brendano method shows diffraction lines having the intensities I₀ and I₁ at diffraction angles 2θs in the ranges of 31.55-31.85° and 24.75-250.5°, respectively, on the condition that the ratio of I₁/I₀ is 0.24 or less.

## Description

### CROSS-REFERENCE TO RELATED APPLICATIONS

This application is based upon and claims the benefit of priority from the prior Japanese Patent Application No. 2013-053697, filed on March 15, 2013, the entire contents of which are incorporated herein by reference.

### FIELD

Embodiments of the present disclosure relate to a phosphor and a light-emitting device. Specifically, the present embodiments relate to a light-emitting device comprising a combination of a particular phosphor and a light-emitting element (for example LED) radiating light with a largely variable peak wavelength.

### BACKGROUND

A white light-emitting device comprises a combination of, for example, a blue light-emitting element, a phosphor that emits red light under excitation by blue light, and another phosphor that emits green light under excitation by blue light. However, if containing a phosphor that emits yellow light under excitation by blue light, the white light-emitting device can be produced by use of fewer kinds of phosphors. As a yellow-light emitting phosphor, Eu-activated orthosilicate phosphor is known, for example.

Meanwhile, in order to enhance the emission intensity, it is general to apply high power to the light-emitting element. However, the high-powered light-emitting element is known to generate heat and hence to elevate the inside temperature of the device, in which the phosphors are included, up to about 100°C to 200°C. When thus heated, phosphors generally lose their emission intensity. In addition, when the temperature increases, the light-emitting element is also known to radiate light at a longer wavelength. Specifically, for example, if the inside temperature rises up to 150°C, the element radiates light with a peak red-shifted by about 10 nm.

As described above, if the above Eu-activated orthosilicate phosphor is combined with a high-powered light-emitting element to produce a light-emitting device, a decrease in the emission intensity of the phosphor occurs. When the temperature of the light-emitting element increases, the phosphor suffers both from the temperature quenching and from the decrease of the excitation intensity to lose the emission intensity thereof. The emission intensity of the phosphor may decrease so remarkably as to often break the balance between the light from the light-emitting element and the luminescence from the phosphor.

### BRIEF DESCRIPTION OF THE DRAWINGS

Figure 1 shows the crystal structure of Sr₂Si₇Al₃ON₁₃.
Figure 2 shows a vertical sectional view schematically illustrating a light-emitting device according to an embodiment.
Figure 3 shows a vertical sectional view schematically illustrating a light-emitting device according to another embodiment.
Figure 4 shows the XRD profile of the phosphor produced in Example 1.
Figure 5 shows the XRD profile of the phosphor produced in Example 2.
Figure 6 shows the XRD profile of the phosphor produced in Comparative example 1.
Figure 7 shows the emission spectra of the phosphors in Examples and Comparative example.
Figure 8 shows the excitation spectra of the phosphors in Examples and Comparative example.

### DETAILED DESCRIPTION

Embodiments will now be explained with reference to the accompanying drawings.

The phosphor according to an embodiment of the present disclosure comprises Ce as an activator. The phosphor has a crystal structure of Sr₂Si₇Al₃ON₁₃ and emits luminescence with a peak in the wavelength range of 500 to 600 nm under excitation by light with a peak in the wavelength range of 250 to 500 nm. The XRD profile thereof measured with Cu-Kα line radiation (wavelength: 1.54056 A) according to Bragg-Brendano method shows diffraction lines having the intensities I₀ and I₁ at diffraction angles 2θs in the ranges of 31.55-31.85° and 24.75-25.05°, respectively, on the condition that the ratio of I₁/I₀ is 0.24 or less.

Since emitting luminescence with a peak wavelength of 500 to 600 nm under excitation by light with a peak wavelength of 250 to 500 nm, the phosphor according to the embodiment is a yellow-emitting phosphor. This phosphor is characterized by having a matrix of essentially the same crystal structure as that of Sr₂Si₇Al₃ON₁₃ (hereinafter, often referred to as "Sr₂Si₇Al₃ON₁₃-type crystal structure"). Further, the phosphor is also characterized in that the matrix is activated with Ce and in that the intensity in its excitation spectrum varies between 90 and 100%, preferably between 93 and 100% in the range of the excitation peak wavelength±10 nm.

A light-emitting device comprising the light-emitting element and the yellow-emitting phosphor according to the embodiment can realize the aimed luminescent color even when working with high power, for example, even when exposed to a current as high as a few hundred milliamperes, and accordingly the device enables to reduce color drift.

The Ce-activated phosphor having the Sr₂Si₇Al₃ON₁₃-type crystal structure has an excitation spectrum in which the intensity decreases gradually from the shorter wavelength side to the longer side in the blue wavelength range (e.g., about 430 to 500 nm) corresponding to the excitation by the light-emitting element. On the other hand, the light-emitting element, which is used for exciting the phosphor, generally generates heat when working with high power, and in accordance with that, the peak wavelength of the light from the light-emitting element is red-shifted.

If the phosphor has an excitation spectrum in which the band edge is also red-shifted, the excitation intensity can be prevented from decreasing in the wavelength range where the peak of light from the light-emitting element is red-shifted. In view of that, the applicant makes it possible to flatten the band in the excitation spectrum of the phosphor having a Sr₂Si₇Al₃ON₁₃-type crystal structure.

Since emitting luminescence with a peak wavelength of 500 to 600 nm under excitation by light with a peak wavelength of 250 to 500 nm, the phosphor according to the present embodiment can emit light in the range of yellowish green to orange. The phosphor of the embodiment thus mainly emits light in the yellow range, and hence is hereinafter referred to as "yellow-emitting phosphor". This phosphor has a matrix of essentially the same crystal structure as that of Sr₂Si₇Al₃ON₁₃, and the matrix is activated with Ce. The yellow-emitting phosphor according to the embodiment is, for example, represented by the following formula (1):

(M₁₋ₓCeₓ)_{2y}Si_{10-z}Al_{z}OᵤN_{w} (1)

in which
M is at least one element selected from the group consisting of Ba, Sr, Ca and Mg, and
x, y, z, u and w satisfy the conditions of
   0<x≤1, preferably 0.001≤x≤0.5,
   0.8≤y≤1.1, preferably 0.85≤y≤1.06,
   2≤z≤3.5, preferably 2.5≤z≤3.3,
   0<u≤1, preferably 0.001≤u≤0.8,
   1.8≤z-u, preferably 2.0≤z-u, and
   13≤u+w≤15, preferably 13.2≤u+w≤14.8, respectively.

As shown in the above formula (1), the metal element M is at least partly replaced with the emission center element Ce. The metal element M is basically Sr, which may be partly replaced with at least one element selected from the group consisting of Ba, Ca and Mg. The metal element M other than Sr is preferably contained in a small amount so that other phases than the Sr₂Si₇Al₃ON₁₃-type crystal structure may not be formed in the production process of the phosphor. Specifically, the amount of Ba, Ca and Mg is preferably 10 mol% or less based on the total amount of M.

If the amount of Ce is 0.1 mol% or more, based on the total amount of M and Ce, the phosphor can have sufficient luminous efficiency. Accordingly, x is preferably 0.001 or more. The metal element M may be completely replaced with Ce (that is, x may be 1), but x is preferably 0.5 or less so as to avoid decrease of the emission probability (namely, to avoid concentration quenching).

The yellow-emitting phosphor according to the embodiment contains Ce as an emission center, and thereby emits light in the range of yellowish green to orange, namely, luminescence with a peak in the wavelength range of 500 to 600 nm, under excitation by light with a peak in the wavelength range of 250 to 500 nm. Even if other elements are contained as unavoidable impurities in an amount of about 10 mol% or less, based on the amount of Ce, they does not impair the aimed effect. Examples of the unavoidable impurities include Tb, Eu and Mn.

y is preferably 0.8 or more, further preferably 0.85 or more, so as to avoid formation of crystal defects and to prevent decrease of the luminous efficiency. On the other hand, however, y is preferably 1.1 or less, further preferably 1.06 or less so that excess of the alkaline earth metal may not deposit in the form of other phases to decrease the luminous efficiency. Accordingly, y satisfies the condition of 0.8≤x≤1.1 preferably, 0.85≤x≤1.06 more preferably.

z is preferably 2 or more, further preferably 2.5 or more so that excess Si may not deposit in the form of other phases to decrease the luminous efficiency. On the other hand, however, it is preferably 3.5 or less, further preferably 3.3 or less so that excess Al may not deposit in the form of other phases to decrease the luminous efficiency. Accordingly, z satisfies the condition of 2≤z≤3.5 preferably, 2.5≤z≤3.3 more preferably.

u is preferably 1 or less, further preferably 0.8 or less so that crystal defects may not increase to lower the luminous efficiency. On the other hand, however, u is preferably 0.001 or more so as to maintain the desired crystal structure and to keep properly the wavelength of the emission spectrum. Accordingly, u satisfies the condition of 0<u≤1 preferably, 0.001≤u≤0.8 more preferably.

The value of z-u is preferably 1.8 or more, further preferably 2.0 or more so that the phosphor of the embodiment can keep the desired crystal structure and also so that other phases may not be formed in the production process of the phosphor. For the same reasons, the value of u+w satisfies the condition of 13≤u+w≤15 preferably, 13.2≤u+w≤14.2 preferably.

Since satisfying all the above conditions, the phosphor according to the present embodiment can efficiently emit yellow light with a wide half-width emission spectrum under excitation by light with a peak in the wavelength range of 250 to 500 nm. As a result, the phosphor enables to realize white light of high color rendering property. Further, the yellow-emitting phosphor of the present embodiment is also excellent in temperature dependence.

The yellow-emitting phosphor according to the present embodiment is based on Sr₂Si₇Al₃ON₁₃, but its constituting elements Sr, Si, Al, O and N can be replaced with other elements and/or Ce to form a solid solution with the matrix. These modifications, such as replacement, often change the crystal structure. However, the atomic positions therein are only slightly changed so that the chemical bonds do not break. Here, the atomic positions depend on the crystal structure, on the sites occupied by the atoms therein and on their atomic coordinates.

The embodiment of the present disclosure leads to the aimed effect as long as the yellow-emitting phosphor does not change its basic crystal structure. There may be a case where the crystal structure of the phosphor differs from that of Sr₂Si₇Al₃ON₁₃ in the lattice constants and/or in the chemical bond lengths (close interatomic distances) of M-N and M-O. However, even in that case, if the differences are within a range of ±15% based on the lattice constants or chemical bond lengths (Sr-N and Sr-O) in Sr₂Si₇Al₃ON₁₃, the crystal structure is defined to be the same. Here, the lattice constants can be determined by X-ray diffraction or neutron diffraction, and the chemical bond lengths (close interatomic distances) of M-N and M-O can be calculated from the atomic coordinates.

The Sr₂Si₇Al₃ON₁₃ crystal belongs to a monoclinic system, especially to an orthorhombic system with lattice constants of, for example, a=11.68 A, b=21.34 A and c=4.95 A. This crystal belongs to the space group Pna21 (which is the 33^{rd} space group listed in International Tables for Crystallography, Volume A: Space-group symmetry, Edited by T. Hahn, Springer (Netherlands))). The chemical bond lengths (Sr-N and Sr-O) in Sr₂Si₇Al₃ON₁₃ can be calculated from the atomic coordinates shown in Table 1.

**Table 1**

| | Site | SOF* | x | y | z |
|---|---|---|---|---|---|
| Sr1 | 4a | 1 | 0.2786 | 0.49060(11) | 0.5284(14) |
| Sr2 | 4a | 1 | 0.3552(3) | 0.69839(12) | 0.048(2) |
| Si/Al1 | 4a | 1 | 0.3582(9) | 0.2769(3) | 0.070(3) |
| Si/Al2 | 4a | 1 | 0.5782(9) | 0.7996(4) | 0.047(5) |
| Si/Al3 | 4a | 1 | 0.5563(8) | 0.4672(3) | 0.543(5) |
| Si/Al4 | 4a | 1 | 0.4724(8) | 0.6092(3) | 0.556(4) |
| Si/Al5 | 4a | 1 | 0.1910(7) | 0.6397(3) | 0.535(4) |
| Si/Al6 | 4a | 1 | 0.0061(8) | 0.5438(3) | 0.546(4) |
| Si/Al7 | 4a | 1 | 0.1625(9) | 0.5661(3) | 0.038(4) |
| Si/Al8 | 4a | 1 | 0.3937(8) | 0.3469(3) | 0.547(4) |
| Si/Al9 | 4a | 1 | 0.1552(18) | 0.3483(8) | 0.318(3) |
| Si/Al10 | 4a | 1 | 0.1525(14) | 0.3492(6) | 0.813(2) |
| O/N1 | 4a | 1 | 0.436(2) | 0.8164(10) | 0.061(11) |
| O/N2 | 4a | 1 | 0.699(2) | 0.4692(10) | 0.513(10) |
| O/N3 | 4a | 1 | 0.334(2) | 0.6355(10) | 0.511(9) |
| O/N4 | 4a | 1 | 0.213(2) | 0.2980(11) | 0.056(12) |
| O/N5 | 4a | 1 | 0.256(2) | 0.3750(10) | 0.563(9) |
| O/N6 | 4a | 1 | 0.894(2) | 0.6002(12) | 0.549(14) |
| O/N7 | 4a | 1 | 0.358(3) | 0.2062(12) | 0.893(6) |
| O/N8 | 4a | 1 | 0.508(2) | 0.4677(12) | 0.885(6) |
| O/N9 | 4a | 1 | 0.398(2) | 0.2727(12) | 0.392(6) |
| O/N10 | 4a | 1 | 0.430(3) | 0.3336(15) | 0.896(7) |
| O/N11 | 4a | 1 | 0.942(3) | 0.4614(15) | 0.371(8) |
| O/N12 | 4a | 1 | 0.662(2) | 0.8571(12) | 0.893(6) |
| O/N13 | 4a | 1 | 0.128(3) | 0.5743(15) | 0.381(7) |
| O/N14 | 4a | 1 | 0.495(3) | 0.3982(13) | 0.383(6) |

| | | | | | |
|---|---|---|---|---|---|
| Remark) SOF*: site occupation factor | | | | | |

The yellow-emitting phosphor according to the present embodiment needs to have the above crystal structure. If the chemical bond lengths are largely changed from the above, they can be broken to form another crystal structure and hence the effect of the present embodiment cannot be obtained.

The yellow-emitting phosphor of the present embodiment is based on an inorganic compound having the same crystal structure as Sr₂Si₇Al₃ON₁₃ (namely, having a Sr₂Si₇Al₃ON₁₃-type crystal structure), but the constituting element M is partly replaced with the emission center element Ce and the amount of each element is restricted. On those conditions, the phosphor according to the present embodiment has high luminous efficiency and shows a wide half-width emission spectrum, and also has favorable properties, such as, excellent temperature dependence.

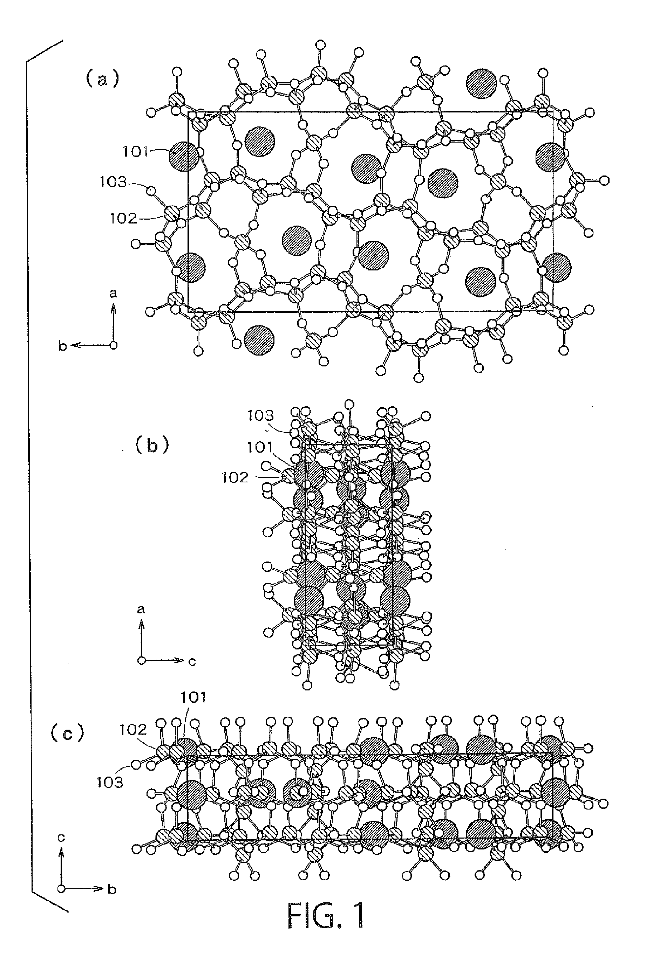

The crystal structure of Sr₂Si₇Al₃ON₁₃ based on the atomic coordinates in Table 1 is illustrated in Figure 1. Figures 1(a), (b) and (c) are projections of the crystal structure along the c, b and a axes, respectively. In Figure 1, 101 represents a Sr atom, which is surrounded by an Al or a Si atom 102 and an O or a N atom 103. The Sr₂Si₇Al₃ON₁₃ crystal can be identified by XRD or neutron diffraction.

The phosphor of the present embodiment has a composition represented by the above formula (1), and shows peaks at particular diffraction angles (2θs) in the X-ray diffraction profile measured with Cu-Kα line radiation (wavelength: 1.54056 A) according to Bragg-Brendano method. This means that its XRD profile has at least ten peaks at the diffraction angles (2θs) of 15.0-15.2°, 22.9-23.1 °, 24.75-25.05°, 25.5-25.9°, 25.85-26.15°, 29.3-29.5°, 30.9-31.1 °, 31.55-31.85°, 32.95-33.25°, 33.45-33.75°, 33.85-34.15°, 34.2-34.6°, 34.95-35.45°, 36.0-36.2°, 36.45-36.75°, 37.1-37.5°, 40.4-40.8° and 56.35-56.85°.

In addition, it is one of the characteristics of the phosphor according to the present embodiment that the peak intensities I₀ and I₁ of diffraction lines at 31.55-31.85° and 24.75-25.05°, respectively, are in a particular ratio. Specifically, the peak intensity ratio I₁/I₀ is necessarily 0.24 or less, preferably 0.20 or less in the phosphor of the present embodiment. If the ratio I₁/I₀ is in that range, the phosphor of the present embodiment has excellent properties. If the ratio is more than 0.24, the excitation band of the phosphor in the blue range is sharpened, and thus the emission efficiency of the phosphor tends to be largely affected by the peak shift of the excitation light. That is presumed to be because the phosphor particles' composition becomes more homogeneous.

The yellow-emitting phosphor according to the present embodiment can be produced by the steps of mixing the raw materials containing the above elements and then firing the mixture.

The material M can be selected from a nitride or a carbide of M; the material containing Al can be selected from a nitride, an oxide or a carbide of Al; the material containing Si can be selected from a nitride, an oxide or a carbide of Si; and the material containing the emission center Ce can be selected from an oxide, a nitride and a carbonate of Ce.

In addition, nitrogen can be supplied from the above nitrides or from a nitrogen-containing firing atmosphere, and oxygen can be supplied from the above oxides or from the oxidized surface of the above nitride particles.

For example, Sr₃N₂, Si₃N₄, Al₂O₃ and AlN, and CeO₂ are mixed in an appropriate amount to give the aimed composition. Sr₃N₂ may be replaced with Sr₂N, SrN, or its mixture. The raw materials are preferably dry-mixed in the order of smaller to larger weights, so as to prepare a homogeneous powder mixture.

The materials are mixed, for example, in a mortar placed in a glove box. The mixed powder is placed in a crucible and then fired on particular conditions to obtain the phosphor according to the embodiment. There are no particular restrictions in the materials of the crucible, which is made of, for example, boron nitride, silicon nitride, silicon carbide, carbon, aluminum nitride, SiAlON, aluminum oxide, molybdenum or tungsten.

The mixed powder is preferably fired under a pressure not less than the atmospheric pressure. Since the silicon nitride decomposes easily, it is advantageous to fire the mixture under a pressure not less than the atmospheric pressure. In order to prevent the silicon nitride from decomposition at a high temperature, the pressure is preferably 5 atm or more and the firing temperature is preferably in the range of 1500 to 2000°C. If those conditions are satisfied, the aimed fired product can be obtained without suffering from troubles such as sublimation of the raw materials and/or of the product. The firing temperature is more preferably in the range of 1800 to 2000°C.

For the purpose of avoiding oxidation of AlN, the firing step is preferably carried out in a nitrogen atmosphere. The atmosphere may contain hydrogen in an amount of about 90 atm% or less.

After the firing step is carried out at the above temperature for 0.5 to 4 hours, the fired product is taken out of the crucible and then ground. The ground product is preferably fired again under the same conditions. If those firing and grinding procedures are repeated from 1 to 10 times, the product has the advantages that the crystal grains are less fused, and further, the composition and the crystal structure of the formed powder is more uniform.

After the firing step, the product is subjected to after-treatment such as washing, if necessary, to obtain a phosphor according to the embodiment. The washing can be carried out, for example, by using pure water or acid. Examples of the acid include: inorganic acids, such as sulfuric acid, nitric acid, hydrochloric acid and hydrofluoric acid; organic acids, such as formic acid, acetic acid and oxalic acid; and mixtures thereof.

After washed with acid, the product may be subjected to post-annealing treatment, if necessary. The post-annealing treatment, which can be carried out, for example, in a reductive atmosphere containing nitrogen and hydrogen, improves the crystallinity and the luminous efficiency.

The yellow-emitting phosphor according to the present embodiment is in the form of particles having minor axis sizes of preferably 45 µm or more, further preferably 75 µm or more. That form enhances the light-absorption and quantum efficiency, and also improves the temperature dependence. Here, the minor axis sizes of the particles are determined by the openings of the sieve with which the particles are classified according to the what-is-called "sieving method". For example, the particles that cannot pass through a sieve having openings of 45 µm can be regarded as having minor axis sizes of 45 µm or more. However, if being too large, the phosphor particles are sparsely distributed on the light-emitting element to often cause troubles such as color splitting. Accordingly, the minor axis sizes are preferably 200 µm or less, more preferably 150 µm or less.

By the above manner, the phosphor according to the present embodiment can be divided into different size ranges by changing the sieves' openings. Particles of the phosphors obtained have generally various sizes. Those particles with various sizes are presumed to be formed because they are different from each other in the firing speed and thus in their composition.

Specifically, the following is thought to be the reason why the particles are formed in different sizes. In the early stage of firing, the raw materials are evenly distributed. Accordingly, when the seed crystals grow, they can be homogeneously formed because the raw materials are evenly present. However, as the crystal growth proceeds, materials around each crystal are gradually consumed to change the distribution of the materials around each crystal. As a result, in the large sized particles, the core part formed in the early stage tends to be different from the superficial part formed in the later stage.

As shown in Table 1, particularly in a crystal of the yellow-emitting phosphor according to the present invention, the atoms of Si and Al can occupy the same sites and so can those of O and N. This means that, even if all the sources of Al, Si, O and N placed around the crystal are not in the same amount, the crystal can grow with different ratios of Si/Al and O/N. Accordingly, there are innumerable kinds of coordination environment around Ce. Since one coordination environment around Ce corresponds to one excitation band, many different coordination environments cause many different excitation bands. Consequently, the larger the phosphor particle is, the broader excitation band it has. The broad excitation band provides such a flat peak in the excitation spectrum that the excitation intensity hardly varies in the range near the peak wavelength.

The phosphor with large sized particles is characterized, for example, in that the emission intensity varies between 90 and 100%, preferably between 93 and 100% even if the excitation peak wavelength fluctuates within ±10 nm. The phosphor, therefore, enables the light-emitting device to suffer less from color drifting even when the temperature is raised by working with high power.

Further, the phosphor particle of large size has a specific surface area larger than that of small size, and hence undergoes less surface scattering and accordingly has a higher rate of photo-absorption. On the other hand, the phosphor particle of large size has the same quantum efficiency as the relatively small one. Because of that, it is possible to produce the phosphor of high luminous efficiency.

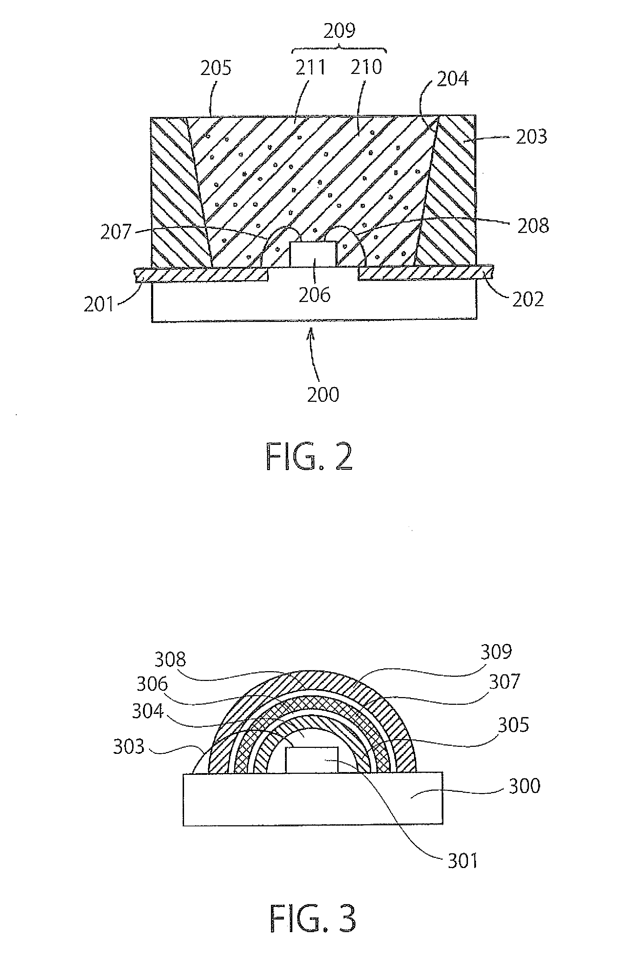

The light-emitting device according to the embodiment comprises a luminescent layer containing the above phosphor and a light-emitting element capable of exciting the phosphor. Figure 2 shows a vertical sectional view schematically illustrating a light-emitting device according to an embodiment of the present disclosure.

The light-emitting device shown in Figure 2 comprises leads 201, 202 and a package cup 203 on a substrate 200. The package cup 203 and the substrate 200 are made of resin. The package cup 203 has a concavity 205 in which the top opening is larger than the bottom. The inside wall of the concavity 205 functions as a reflective surface 204.

At the center of the nearly circular bottom of the concavity 205, there is a light-emitting element 206 mounted with Ag paste or the like. The light-emitting element 206 radiates light with a peak in the wavelength range of 400 to 500 nm. Examples of the light-emitting element 206 include light-emitting diodes and laser diodes, such as GaN type semiconductor light-emitting chips, but they by no means restrict the light-emitting element.

The p- and n-electrodes (not shown) of the light-emitting element 206 are connected to the leads 201 and 202 by way of bonding wires 207 and 208 made of Au or the like, respectively. The positions of the leads 201 and 202 can be adequately modified.

The light-emitting element 206 may be of a flip chip type in which the n- and p-electrodes are placed on the same plane. This element can avoid troubles concerning the wires, such as disconnection or dislocation of the wires and light-absorption by the wires. In that case, therefore, it is possible to obtain a semiconductor light-emitting device excellent both in reliability and in luminance. Further, it is also possible to adopt a light-emitting element having an n-type substrate so as to produce a light-emitting device constituted as described below. In that device, an n-electrode is formed on the back surface of the n-type substrate while a p-electrode is formed on the top surface of a p-type semiconductor layer beforehand laid on the substrate. The n-electrode is mounted on one of the leads, and the p-electrode is connected to the other lead by way of a wire. As described above, the phosphor according to the embodiment shows an emission spectrum whose intensity hardly varies even if the excitation light source provides light of fluctuating wavelength. Specifically, it is possible to reduce variation of emission intensity from the phosphor even when the light-emitting element in the light-emitting device is continuously worked to raise the temperature and accordingly to radiate light with a fluctuating peak wavelength. For example, the peak wavelength of light from the light- emitting element varies by about 10 nm between at the time within 5 seconds from when power is turned on and at the time when the temperature elevated by the power becomes constant. Accordingly, even if the adopted light-emitting element radiates light of wavelength fluctuating by 10 nm, the light-emitting device according to the embodiment can realize stable emission.

In the concavity 205 of the package cup 203, there is a luminescent layer 209 containing the phosphor 210 according to an embodiment of the present disclosure. In the luminescent layer 209, the phosphor 210 is contained in a resin layer 211 made of, for example, silicone resin in an amount of 5 to 60 wt%. As described above, the fluorescent substance according to the embodiment comprises Sr₂Si₇Al₃ON₁₃ matrix. Since that kind of oxynitride has high covalency, the fluorescent substance of the embodiment is generally so hydrophobic that it has good compatibility with the resin. Accordingly, scattering at the interface between the resin and the fluorescent substance is prevented enough to improve the light-extraction efficiency.

The yellow-emitting phosphor according to the embodiment has good temperature dependence, and can efficiently emit yellow light with a wide half-width emission spectrum. This phosphor is used in combination with a light-emitting element radiating light with a peak in the wavelength range of 400 to 500 nm, and thereby it becomes possible to provide a white light-emitting device excellent in luminescent properties.

The size and kind of the light-emitting element 206 and the dimension and shape of the concavity 205 can be properly changed.

The light-emitting device according to an embodiment of the present disclosure is not restricted to the package cup-type shown in Figure 2, and can be freely applied to any type of devices. For example, even if the phosphor of the embodiment is used in a shell-type or surface-mount type LED, the same effect can be obtained.

Figure 3 shows a vertical sectional view schematically illustrating a light-emitting device according to another embodiment of the present disclosure. In the shown device, p- and n-electrodes (not shown) are formed at the predetermined positions on a heat-releasing insulating substrate 300, and a light-emitting element 301 is placed thereon. The heat- releasing insulating substrate is made of, for example, AIN.

On the bottom of the light-emitting element 301, one of the electrodes of the element is provided and electrically connected to the n-electrode of the heat-releasing insulating substrate 300. The other electrode of the light-emitting element 301 is connected to the p-electrode (not shown) on the heat-releasing insulating substrate 300 by way of a gold wire. The light-emitting element 301 is a light-emitting diode radiating light with a peak in the wavelength range of 400 to 500 nm.

The light-emitting element 301 is successively domed with an inner transparent resin layer 304, a luminescent layer 305 and an outer transparent resin layer 306 in this order. The inner and outer transparent resin layers 304 and 306 are made of, for example, silicone resin.

In the production process of the light-emitting device shown in Figure 3, the luminescent layer 305, which contains the yellow-emitting phosphor of the embodiment, can be easily formed by use of techniques such as vacuum printing and drop-coating from a dispenser. Further, since positioned between the inner and outer transparent resin layers 304 and 306, the luminescent layer 305 also has the function of improving the extraction efficiency.

The luminescent layer in the light-emitting device according to the embodiment may contain not only the yellow-emitting phosphor of the embodiment but also another phosphor emitting green luminescence under excitation by blue light and still another phosphor emitting red luminescence under excitation by blue light. If comprising that luminescent layer, the produced white light-emitting device is further improved in color rendering properties.

Even when excited by UV light with a peak in the wavelength range of 250 to 400 nm, the yellow-emitting phosphor of the embodiment gives off yellow luminescence. Accordingly, the phosphor of the embodiment can be combined with, for example, another phosphor emitting blue light under excitation by UV light and a UV light-emitting element such as a UV light-emitting diode, to produce a white light-emitting device. In that white light-emitting device, the luminescent layer may contain not only the yellow-emitting phosphor of the embodiment but also a phosphor emitting luminescence with a peak in another wavelength range under excitation by UV light. That phosphor is, for example, a phosphor emitting red light under excitation by UV light or a phosphor emitting green light under excitation by UV light.

As described above, the phosphor according to the embodiment has good temperature dependence characteristics, and can efficiently emit yellow light with an emission spectrum having a wide half-width. That yellow-emitting phosphor of the embodiment is combined with a light-emitting element radiating light with a peak in the wavelength range of 250 to 500 nm, and thereby it becomes possible to produce a white light-emitting device excellent in luminescent properties by use of fewer kinds of phosphors.

The luminescent layer in the device according to the embodiment may be formed, for example, in such a manner that a required number of the phosphor particles for realizing white color are directly one-by-one placed on the blue-light emitting element. If worked with high power, the light-emitting element is exposed to a large electric current and hence raises the temperature considerably high. In that case, it is necessary to form a resin-less luminescent layer, which contains no resin. Accordingly, if the phosphor particles directly placed on the light-emitting element are used as the luminescent layer, they enable to produce a light-emitting device which is free from deterioration of the resin, which has high luminous efficiency and which suffers less from color drift.

The following are concrete examples of the fluorescent substance and the light-emitting device according to the embodiment.

### Examples 1 and 2 and Comparative example 1

As the raw materials, Sr₃N₂, CeO₂, Si₃N₄ and AlN were prepared and weighed out in the blending amounts of 2.851 g, 0.103 g, 5.086 g and 1.691 g, respectively, in a glove box. The materials were then dry-mixed in a planetary ball mill. The obtained mixture was laid in a crucible made of boron nitride (BN) and then fired at 1750°C for 0.5 hour under 7.5 atm in a nitrogen atmosphere. Additionally, the fired product was further fired five times on the same conditions. The obtained phosphor was classified with sieves into the following phosphors:
Phosphor 1: which passed through a sieve having openings of 150 µm but not through a sieve of 75 µm;
Phosphor 2: which passed through a sieve having openings of 75 µm but not through a sieve of 45 µm; and
Phosphor 3: which passed through a sieve having openings of 45 µm.

Each phosphor has a yellow body color, and was observed to emit yellow luminescence when excited by black light. The composition of each phosphor was measured by ICP analysis. The results were as follows:
Phosphor 1: (Sr_{0.98}Ce_{0.02})_{1.9}Si_{7.4}Al_{2.6}O_{0.5}Ni_{3.0};
Phosphor 2: (Sr_{0.98}Ce_{0.02})_{1.9}Si_{7.3}Al_{2.7}O_{0.5}N_{12.9}; and
Phosphor 3: (Sr_{0.98}Ce_{0.02})_{1.9}Si_{6.9}Al_{3.1}O_{0.5}N_{12.9}.

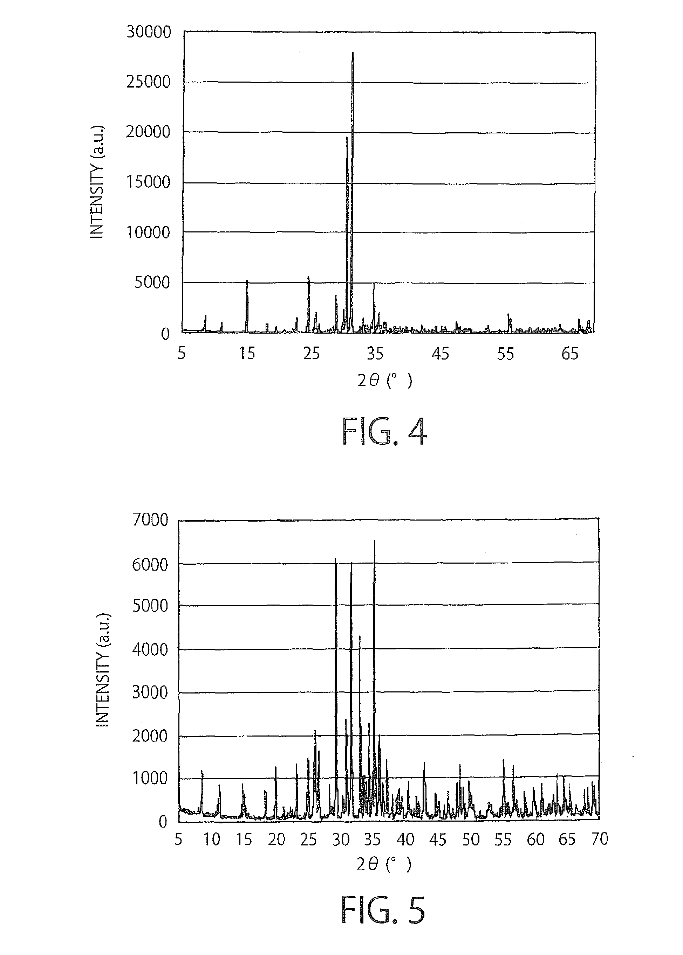

Further, the phosphors were subjected to XRD measurement. The results were shown in Figures 4 to 6. From each of the obtained XRD profiles, the intensities I₀ and I₁ of diffraction lines at diffraction angles 2θs in the ranges of 31.55-31.85° and 24.75-25.05°, respectively, were obtained to calculate the ratio of I₁/I₀. The results are shown in Table 2.

**Table 2**

| | Peak position (° ) | Peak intensity | Peak position (° ) | Peak intensity | Intensity ratio I₁/I₀ |
|---|---|---|---|---|---|
| Phosphor 1 | 31.71 | 27990.8 | 24.92 | 5582.6 | 0.1994 |
| Phosphor 2 | 31.65 | 6031.0 | 24.96 | 1413.6 | 0.2344 |
| Phosphor 3 | 31.70 | 9711.4 | 24.95 | 5452.7 | 0.5615 |

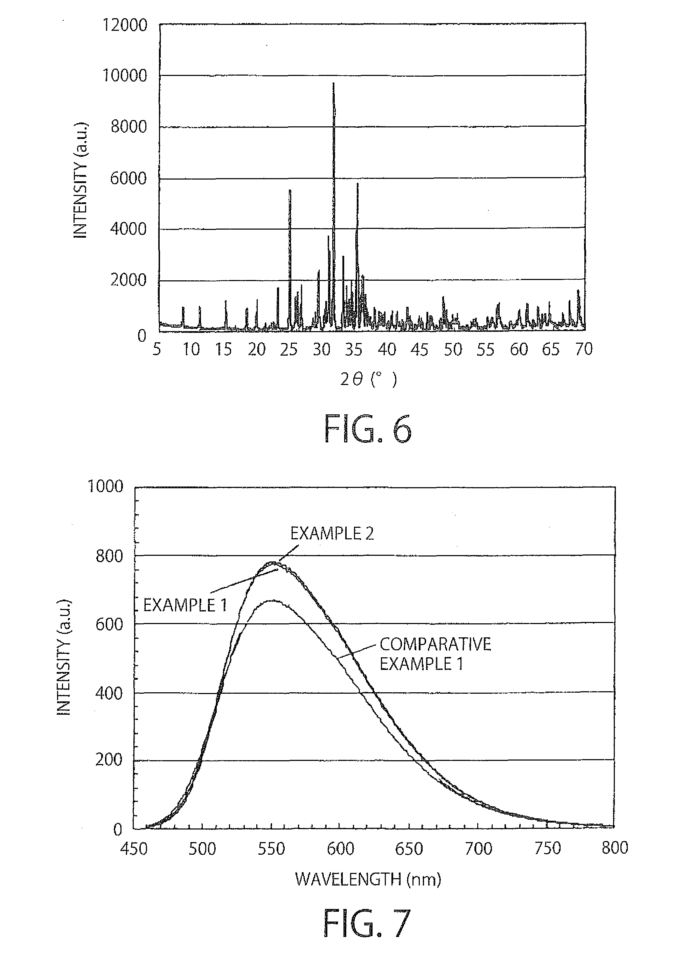

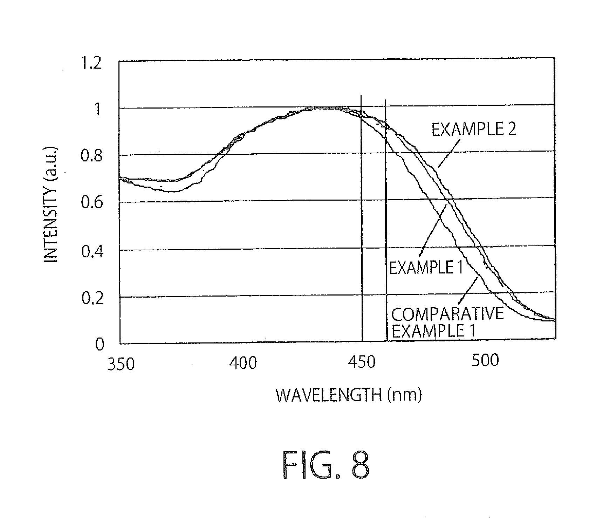

Furthermore, for each phosphor, the emission spectra under excitation by light of 450 nm and the excitation spectra monitored at 548 nm were measured by the absolute PL quantum yield measurement system ([trademark], manufactured by Hamamatsu Photonics K.K.). The results are shown in Figures 7 and 8. From those results, it was verified that, although all the phosphors emit luminescence with peaks around 550 nm, Phosphors 1 and 2 show excitation spectra having flat intensity near the peak, particularly, in the range of 440 to 460 nm as compared with Phosphor 3, and hence that they can emit stable luminescence even when the excitation light peak wavelength fluctuates. Since the emission intensity is thus stable even if the excitation light peak wavelength fluctuates, the light-emitting device radiates light suffering less from color drift even when the temperature is raised by working thereof.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

1. A phosphor comprising Ce as an activator, wherein said phosphor has a crystal structure of Sr₂Si₇Al₃ON₁₃ and emits luminescence with a peak in the wavelength range of 500 to 600 nm under excitation by light with a peak in the wavelength range of 250 to 500 nm, and whose XRD profile measured with Cu-Kα line radiation according to Bragg-Brendano method shows diffraction lines having the intensities I₀ and I₁ at diffraction angles 2θs in the ranges of 31.55-31.85° and 24.75-25.05°, respectively, on the condition that the ratio of I₁/I₀ is 0.24 or less.

2. The phosphor according to claim 1, wherein said ratio of I₁/I₀ is 0.2 or less.

3. The phosphor according to claim 1, which is represented by the following formula (1):
(M₁₋ₓCeₓ)_{2y}Si_{10-z}Al_{z}OᵤN_{w} (1)
in which
M is at least one element selected from the group consisting of Ba, Sr, Ca and Mg, and
x, y, z, u and w satisfy the conditions of
0<x≤1,
0.8≤y≤1.1,
2≤z≤3.5,
0<u≤1,
1.8≤z-u, and
13≤u+w≤15, respectively.

4. The phosphor according to claim 1, comprising phosphor particles which have minor axis sizes of 45 µm or more.

5. A light-emitting device comprising
a light-emitting element radiating light with a peak in the wavelength range of 400 to 500 nm, and
a luminescent layer containing a phosphor emitting yellow light under excitation by the light from said light-emitting element; wherein
said luminescent layer contains the phosphor according to claim 1.

6. The light-emitting device according to claim 5, wherein the peak wavelength of the light from said light-emitting element varies by about 10 nm between at the time within 5 seconds from when power is turned on and at the time when the temperature elevated by the power becomes constant.

7. The light-emitting device according to claim 5, wherein said luminescent layer further contains a green-light emitting phosphor and a red-light emitting one.

8. A method for producing the phosphor according to claim 1, comprising the steps of
mixing
a material containing M selected from a nitride or a carbide of M,
a material containing Al selected from a nitride, an oxide or a carbide of Al,
a material containing Si selected from a nitride, an oxide or a carbide of Si, and
a material containing Ce selected from an oxide, a nitride or a carbonate of Ce, to prepare the mixture; and then
firing the mixture.

9. The method according to claim 8, wherein said step of firing is carried out at a temperature of 1500 to 2000°C under 5 atm or more.

10. The method according to claim 8, wherein said step of firing is carried out in a nitrogen atmosphere.

11. The method according to claim 8, which further comprises the step of washing the product after the step of firing.

12. The method according to claim 8, which furthermore comprises the step of classifying the fired product with a sieve so as to remove particles having small minor axis sizes.

13. The method according to claim 12, wherein said sieve has openings of 45 µm or more.
